# EUROPEAN PATENT APPLICATION

(11) **EP 3 502 061 A1**
(43) Date of publication of application: **26.06.2019**
(21) Application number: 18212999.9
(22) Date of filing: 17.12.2018
(51) Int. Cl.: C02F 1/44, C02F 1/52, C23C 18/12, H01L 31/0392, H01L 31/0749, C01G 11/02, C02F 101/10, C02F 101/20, C02F 103/34, C02F 103/40

(54) **WASTE LIQUID RECOVERY SYSTEM, CHEMICAL BATH DEPOSITION DEVICE AND DEPOSITION METHOD**

(30) Priority: 20.12.2017 CN 201711386486
(71) Applicant: Beijing Apollo Ding Rong Solar Technology Co., Ltd., Beijing 100176 (CN)
(72) Inventor: WANG, Lei, BEIJING, Beijing 100176 (CN)
(74) Representative: Peguet, Wilfried

(57) **Abstract**

The present disclosure provides a waste liquid recovery system, a chemical bath deposition device and a deposition method, the waste liquid recovery system comprises a waste liquid storage tank for storing the waste liquid generated by deposition of a cadmium sulfide deposition tank; a refrigeration device for refrigerating the stored waste liquid; a filtering device for filtering the waste liquid obtained after refrigerating; and a chemical liquid storage tank for storing the filtered waste liquid. The waste liquid recovery system, the chemical bath deposition device and the deposition method provided by the present disclosure provide a chemical liquid having the same concentration as an original liquid by refrigerating and filtering the waste liquid, and then replenishing the chemical raw material, thereby greatly improving the recycling of waste liquid and reducing a production cost.

## Description

### CROSS-REFERENCE TO RELATED APPLICATION

This application claims priority of Chinese Patent Application No. 201711386486.7 entitled with "chemical bath deposition device and deposition method , waste liquid recovery system" submitted on December 20, 2017, the entire content of which is incorporated herein by reference.

### TECHNICAL FIELD

The present disclosure relates to a production technology of a solar cell, particularly to a chemical bath deposition device and a deposition method , a waste liquid recovery system.

### BACKGROUND

As one of the most advanced thin film power generation technologies, a copper indium gallium selenide (CIGS) solar cell technology has a very broad industrialization prospect. Its products can be based on large-size substrates of rigid glass, and can be used to build photovoltaic power stations in areas with strong lighting, as well as building curtain walls, photovoltaic building integration (BIPV) etc. At the same time, the copper indium gallium selenide photovoltaic module can also be made into a flexible small size product, and its soft and thin characteristics can make it stand out in portable power generation products, such as thin film power generation paper, power generation backpack and so on.

Cadmium sulfide (CdS) is the best n-junction buffer material found to date in the production of CIGS photovoltaic modules. The interface between a CdS layer and a CIGS layer is a p-n junction for a separation of excitons generated after light absorption, so the effect (especially compactness) of CdS layer deposition has a great influence on an efficiency of the module.

However, there is still a need in the art to further improve a deposition process of CdS, particularly to improve a recovery of waste liquid after CdS deposition.

### SUMMARY

The present disclosure provides a waste liquid recovery system, a chemical bath deposition device, and a deposition method.

First Part, according to the present disclosure, there is provided a waste liquid recovery system, including:
a waste liquid storage tank configured to store waste liquid generated in a cadmium sulfide deposition tank;
a refrigeration device configured to refrigerate the stored waste liquid;
a filtering device configured to filter the refrigerated waste liquid;
a chemical liquid storage tank configured to store the filtered waste liquid;
an inlet of the waste liquid storage tank is configured to be connected to an outlet of the cadmium sulfide deposition tank ;
an outlet of the waste liquid storage tank is connected to an inlet of the refrigeration device;
an outlet of the refrigeration device is connected to an inlet of the filtering device; and
an outlet of the filtering device is connected to a waste inlet of the chemical liquid storage tank.

Optionally, the waste liquid recovery system further comprises a cooling device, the cooling device is covered on an outer wall of the waste liquid storage tank, substantially, a coolant in the cooling device is water.

Optionally, the outlet of the chemical liquid storage tank is connected to the inlet of the cadmium sulfide deposition tank, and a first regulating valve is provided between the outlet of the chemical liquid storage tank and the inlet of the cadmium sulfide deposition tank).

Optionally, the waste liquid recovery system further comprises a heat preservation device, the heat preservation device is provided on an outer wall of the chemical liquid storage tank, and used for maintaining a temperature in the chemical liquid storage tank at a set temperature range.

Second Part, according to the present disclosure, there is also provided a chemical bath deposition device, including:
a cadmium sulfide deposition tank configured to deposit cadmium sulfide;
a waste liquid storage tank configured to store the waste liquid generated by deposition of the cadmium sulfide;
a refrigeration device configured to refrigerate the stored waste liquid;
a filtering device configured to filter the refrigerated waste liquid;
a chemical liquid storage tank configured to store the filtered waste liquid; and
a replenishing feeding device configured to replenish a chemical raw material into the chemical liquid storage tank;
an inlet of the waste liquid storage tank is connected to an outlet of the cadmium sulfide deposition tank;
an outlet of the waste liquid storage tank is connected to an inlet of the refrigeration device;
an outlet of the refrigeration device is connected to an inlet of the filtering device;
an outlet of the filtering device is connected to a waste inlet of the chemical liquid storage tank;
an outlet of the replenishing feeding device is connected to an inlet of the raw material of the chemical liquid storage tank;
an outlet of the chemical liquid storage tank is connected to an inlet of the cadmium sulfide deposition tank.

Optionally, the chemical bath deposition device further comprises a cooling device, the cooling device is covered on an outer wall of the waste liquid storage tank, substantially, a coolant in the cooling device is water.

Optionally, a first regulating valve is provided between the outlet of the chemical liquid storage tank and the inlet of the cadmium sulfide deposition tank; and a second regulating valve is provided between the outlet of the replenishing feeding device and the inlet of the chemical liquid storage tank.

Optionally, the chemical bath deposition device further comprises an electrical conductivity detector, the electrical conductivity detector is provided in the chemical liquid storage tank to measure an electrical conductivity of the waste liquid in the chemical liquid storage tank.

Optionally, the chemical bath deposition device further comprises an ion detector, and the ion detector is provided in the chemical liquid storage tank to measure a concentration of Cd2+ contained in the waste liquid of the chemical liquid storage tank.

Optionally, the chemical bath deposition device further comprises a control apparatus, the control apparatus is provided to control opening and closing of the second regulating valve according to the electrical conductivity measured by the electrical conductivity detector or the Cd2+ concentration measured by the ion detector.

Optionally, the chemical bath deposition device further comprises a heat preservation device, the heat preservation device is provided on an outer wall of the chemical liquid storage tank for maintaining a temperature in the chemical liquid storage tank within a set temperature range.

Third part, the present disclosure also provides a deposition method using the chemical bath deposition device of the present disclosure, wherein the deposition method comprises:
introducing the waste liquid in the cadmium sulfide deposition tank into the waste liquid storage tank for storage, and then introducing the waste liquid in the waste liquid storage tank into the refrigeration device for refrigerating;
introducing the refrigerated waste liquid into a filtering device for filtration;
introducing the filtered waste liquid into a chemical liquid storage tank for storage;
adding a chemical raw material to the chemical liquid storage tank by the replenishing feeding device;
introducing a chemical liquid generated by the waste liquid stored in the chemical liquid storage tank and the added chemical raw material into the cadmium sulfide deposition tank for depositing the cadmium sulfide.

Optionally, when the waste liquid in the cadmium sulfide deposition tank is introduced into the waste liquid storage tank for storage, the waste liquid stored in the waste liquid storage tank is cooled to a temperature ranging from 20 °C to 30 °C.

Optionally, the waste liquid in the waste liquid storage tank is introduced into the refrigeration device for refrigerating, a temperature of the refrigerated waste liquid is less than or equal to 15 °C.

Optionally, before adding a chemical raw material to the chemical liquid storage tank by the replenishing feeding device, the deposition method further comprises: monitoring an electrical conductivity of the waste liquid stored in the chemical liquid storage tank or monitoring the Cd2+ concentration of the waste liquid in the chemical liquid storage tank, calculating the content of cadmium particles in the waste liquid, according to the measured electrical conductivity or Cd2+ concentration, and then obtaining the concentration of the added chemical raw material according to the content of the cadmium particles.

### BRIEF DESCRIPTION OF THE Drawing

FIG.1 is a schematic structural diagram of a waste liquid recovery system according to some embodiments of the present disclosure;
FIG.2 is a schematic structural diagram of a chemical bath deposition device according to some embodiments of the present disclosure;
FIG.3 is a schematic structural diagram of a chemical bath deposition device provided by a specific embodiment of the present disclosure;
FIG.4 is a flow chart of a method for depositing a cadmium sulfide layer according to an embodiment of the present disclosure;
FIG.5 is a flow chart of a method for depositing a cadmium sulfide layer according to an embodiment of the present disclosure;
FIG. 6 is a flowchart of a waste liquid recovery method according to an embodiment of the present disclosure.

### DETAILED DESCRIPTION

The embodiments of the present disclosure are described in detail below, and the examples of the embodiments are illustrated in the accompanying drawings, wherein the same or similar reference numerals are used to refer to the same or similar elements or elements having the same or similar functions. The embodiments described below with reference to the accompanying drawings are intended to be illustrative only, and are not to be considered as limiting.

A deposition technique of a CdS film layer is mainly based on a chemical water bath deposition method, namely Chemical Bath Deposition (CBD). When preparing photovoltaic cell chips such as CIGS, CIS, GaAs, etc., a CdS film layer is deposited on a substrate with a back electrode and an absorber layer such as CIGS, CIS, GaAs in sequence as a buffer layer of the photovoltaic cell to form a p-n junction with the absorption layer, thereby completing a photoelectric efficient conversion process.

The CdS deposition process mainly comprises the steps of premixing the chemical deposition solution (including a cadmium compound, an OH⁻ compound and an NH₄⁺ source, etc.), adding a sulfide (such as thiourea), heating the chemical deposition solution, growing CdS on the substrate, taking out the substrate, and discharging the waste liquid. The NH₄⁺ source may be ammonia water, which provides an ammonia source for formation of Cd(NH₄)²⁺ buffer ions for CdS deposition.

Since more than 80% of the chemical raw materials in the waste liquid are dissolved in the solution and no reaction occurs, all the discharged waste liquids cause a great waste, and at the same time, the waste water treatment system is overburdened. The amount of waste that is ultimately discharged into an environment is also considerable, putting a pressure on the environment to a certain degree.

In order to further solve the problem of recycling of a waste liquid in the process of depositing CdS buffer layer by CBD method, the present disclosure provides a chemical bath deposition device, method, and system. After purifying the waste liquid and adding the corresponding chemical raw materials by an appropriate method, the resultant can theoretically be used as a chemical liquid for CdS deposition, and used for subsequent substrates.

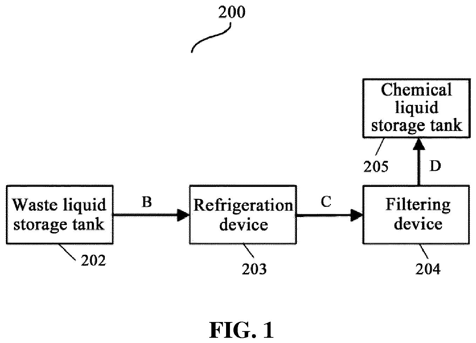

FIG. 1 is a schematic structural diagram of a waste liquid recovery system according to some embodiments of the present disclosure. As shown in FIG. 1, the waste liquid recovery system 200 comprises: a waste liquid storage tank 202, a refrigeration device 203, a filtering device 204, and a chemical liquid storage tank 205. The waste liquid storage tank 202 is used for storing a waste liquid generated by deposition of a cadmium sulfide deposition tank; the refrigeration device 203 is used for refrigerating the stored waste liquid B; the filtering device 204 is used for filtering the waste liquid obtained by refrigerating and the chemical liquid storage tank 205 is used for storing the filtered waste liquid. An inlet of the waste liquid storage tank 202 is connected to an outlet of the cadmium sulfide deposition tank; an outlet of the waste liquid storage tank 202 is connected to an inlet of the refrigeration device 203; an outlet of the refrigeration device 203 is connected to an inlet of the filtering device 204 and an outlet of the filtering device 204 is connected to a waste inlet of the chemical liquid storage tank 205.

Specifically, after the cadmium sulfide deposition chemical reaction is completed and the substrate is taken out, the chemical liquid in the chemical bath deposition tank is introduced into the waste liquid storage tank 202 as waste liquid A (not shown). Preferably, the waste liquid A is pumped into the waste liquid storage tank by the first power pump.

After the waste liquid A enters the waste liquid storage tank 202, a temperature is lowered, thereby forming a cooled waste liquid B. The composition of the waste liquid B is substantially the same as that of the waste liquid A, but the cadmium sulfide particles in the waste liquid B are slightly increased due to the decreased temperature.

The cooled waste liquid B enters the refrigeration device 203 from the inlet of the refrigeration device 203, and is further refrigerated. The waste liquid is refrigerated to form a waste liquid C. The composition of the waste liquid C is substantially the same as that of the waste liquid B, but more precipitation such as cadmium sulfide particles and cadmium compounds is generated by the refrigeration.

The waste liquid recovery system 200 preferably further comprises a cooling device 211, and a coolant in the cooling device is preferably water. The cooling device 211 is covered on the outer wall of the waste liquid storage tank, and used for cooling the waste liquid in the waste liquid storage tank 202, initially reducing a generation rate of CdS. After the cooling by the cooling device in the waste liquid storage tank 202, the solution in the waste liquid storage tank is cooled from 50 to 70 °C at the time of inlet to 20 to 30 °C, preferably 22 °C.

The waste liquid from the waste liquid storage tank will be pumped into the refrigeration device 203 for further cooling. The temperature of the waste liquid in the refrigeration device 203 is reduced to 15 °C or less, such as 5 °C, 8 °C, so that the formation of CdS enters a stagnant state. As the temperature decreases, the solubility of cadmium sulfide in the waste liquid gradually decreases, and the cadmium sulfide in the waste liquid gradually precipitates in the form of cadmium sulfide particles (particles).

A specific structure of the above refrigeration device may be various, and may be a physical refrigeration device or a chemical refrigeration device, which will not be repeated here.

The waste liquid C refrigerated by the refrigeration device will enter the filtering device 204 equipped with a filter element (about 0.02 µm), which filters the CdS particles in the waste liquid, and also filters out the separated chemical raw materials: cadmium sulfate and thiourea.

After passing through the filtering device 204, the solid particles such as CdS are filtered out. This purified chemical liquid will be pumped into the chemical liquid storage tank 205. The outer wall of the chemical liquid storage tank 205 is preferably provided with a cryogenic maintenance device, and the cryogenic maintenance device is used for maintaining the temperature in the chemical liquid storage tank at a set temperature range so as to ensure that the solution is kept at a low temperature.

Thereby, the waste liquid recovery system provide a chemical liquid having the same concentration as the original liquid by refrigerating and filtering the waste liquid, and then replenishing the chemical raw material, and thus compared with the prior art, recycling of waste liquid is greatly improved, and a production cost is reduced.

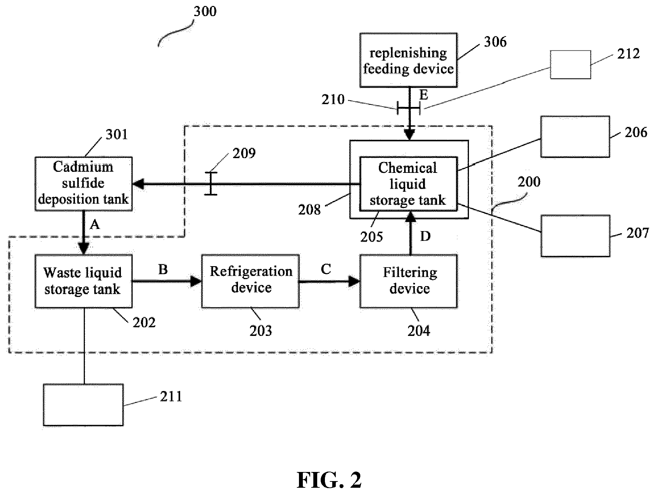

Fig.2 is a schematic structural diagram of a chemical bath deposition device according to some embodiments of the present disclosure. As shown in FIG. 2, these embodiments provide a chemical bath deposition device 300, including a cadmium sulfide deposition tank 301, a waste liquid storage tank 202, a refrigeration device 203, a filtering device 204, a chemical liquid storage tank 205 and a replenishing feeding device 306. As described above, the waste liquid storage tank 202, the refrigeration device 203, the filtering device 204, and the chemical liquid storage tank 205 constitute the waste liquid recovery system 200.

The cadmium sulfide deposition tank 301 described above is used for depositing cadmium sulfide;
the waste liquid storage tank 202 described above is used for storing the waste liquid generated by the deposition of the cadmium sulfide;
the refrigeration device 203 described above is used for refrigerating the waste liquid;
the filtering device 204 described above is used for filtering the waste liquid obtained after cooling;
the chemical liquid storage tank 205 described above is used for storing the filtered waste liquid; and
the replenishing feeding device 306 described above is used for replenishing the chemicals into the chemical liquid storage tank;
the inlet of the waste liquid storage tank 202 described above is connected to an outlet of the cadmium sulfide deposition tank 301;
the outlet of the waste liquid storage tank 202 described above is connected to the inlet of the refrigeration device 203;
the outlet of the refrigeration device 203 described above is connected to the inlet of the filtering device 204;
the outlet of the filtering device 204 described above is connected to the inlet of the chemical liquid storage tank 205; and
the outlet of the chemical liquid storage tank 205 is connected to the inlet of the cadmium sulfide deposition tank 301.

The inlet of the waste liquid storage tank 202 is connected to the outlet of the cadmium sulfide deposition tank 301, the outlet of the waste liquid storage tank 202 is connected to the inlet of the refrigeration device 203, the outlet of the refrigeration device 203 is connected to the inlet of the filtering device 204, the outlet of the filtering device 204 is connected to the inlet of the chemical liquid storage tank 205, the replenishing feeding device 306 is used for replenishing chemicals into the chemical liquid storage tank, and the outlet of the chemical liquid storage tank 205 is connected to the inlet of the cadmium sulfide deposition tank 301.

Referring to FIG. 2, a chemical deposition solution may be added to the cadmium sulfide deposition tank 301, and the chemical deposition solution may include a cadmium compound, an OH⁻ compound, a NH₄⁺ source, or a sulfur compound.

Preferably, the specific steps of adding the chemical deposition solution to the cadmium sulfide deposition tank 301 are: first adding a mixture of a cadmium compound, an OH⁻ compound, and a NH₄⁺ source, heating the mixture to 50 to 70 °C, preferably 60 °C, and then adding a substrate to be treated on the surface , and then adding a sulfide.

Preferably, the cadmium compound may be any one of cadmium sulfate, cadmium chloride, cadmium acetate, cadmium nitrate or any mixture .

Preferably, the OH⁻ compound may be any one of KOH, NaOH, ammonia water or any mixture .

Preferably, the NH₄⁺ source may be any one of ammonia water, ammonium acetate, urea, or a mixture .

Preferably, the sulfur compound may be any one of thiourea, sodium sulfite or any mixture .

Preferably, the chemical deposition solution may further include an auxiliary agent such as urea, ammonia acetate or the like for improving a crystal form of the cadmium sulfide film deposited on the substrate.

Preferably, when a chemical deposition solution is added to the cadmium sulfide deposition tank 301, the specific order of adding the materials is the cadmium compound, the ammonium source, the substrate to be deposited on the surface, and the sulfide.

After the chemical deposition solution is added to the cadmium sulfide deposition tank 301, a chemical reaction starts, that is, the cadmium sulfide particles are formed. Thereby, a cadmium sulfide layer can be deposited on the substrate.

Preferably, the chemical deposition solution comprises cadmium sulfate, ammonia water, and thiourea.

The waste liquid A generated after the deposition of cadmium sulfide flows from the cadmium sulfide deposition tank 301 into the waste liquid storage tank 202, The waste liquid A contains cadmium sulfide particles which are not deposited on the substrate, excess cadmium compounds (such as cadmium sulfate), excess NH₄⁺ source, excess sulfur compounds, and the like.

In some embodiments, the chemical deposition solution may be a cadmium sulfate solution system comprising a solution prepared from cadmium sulfate, ammonia water, and thiourea, and the waste liquid A comprises cadmium sulfate, cadmium sulfide particles, aqueous ammonia, and thiourea.

In some embodiments, the chemical deposition solution may be a cadmium chloride solution system comprising a solution prepared from cadmium chloride, ammonia, and thiourea. The waste liquid A contains cadmium chloride, cadmium sulfide particles, ammonia water, and thiourea.

In some embodiments, preferably, the chemical deposition solution may be a cadmium acetate solution system comprising a solution prepared from cadmium acetate, ammonia water, and thiourea, thereby the waste liquid A comprises cadmium acetate, cadmium sulfide particles, ammonia water, and thiourea.

After the waste liquid A enters the waste liquid storage tank 202, the temperature is lowered, thereby forming the cooled waste liquid B. The composition of the waste liquid B is substantially the same as that of the waste liquid A, but the cadmium sulfide particles in the waste liquid B are slightly increased due to the decreased temperature.

The cooled waste liquid B enters the refrigeration device 203 from the inlet of the refrigeration device 203, and is further refrigerated. The waste liquid is refrigerated to form a waste liquid C. The composition of the waste liquid C is substantially the same as that of the waste liquid B, but more precipitation such as cadmium sulfide particles and cadmium compounds is generated due to the refrigeration.

The replenished chemicals may be a cadmium compound, a NH₄⁺ source or a sulfur compound, in particular cadmium sulfate, ammonia water or thiourea.

After the chemical reaction is completed and the substrate is taken out, the chemical liquid in the chemical bath deposition tank is introduced into the waste liquid storage tank 202 as a waste liquid, preferably, the waste liquid in the cadmium sulfide deposition tank 301 is pumped into the waste liquid storage tank 202 through a first power pump.

It can be understood by those skilled in the art that the chemical bath deposition device provided by the embodiment of the present disclosure may further include a second power pump, a third power pump, a fourth power pump, and a fifth power pump, wherein the second power pump is used to pump the waste liquid in the waste liquid storage tank 202 into the refrigeration device 203; the third power pump is used to pump the waste liquid in the refrigeration device 203 into the filtering device; the fourth power pump is used to pump the chemical liquid in the filtering device into the chemical liquid storage tank; and the fifth power pump is used to pump the liquid in the chemical liquid storage tank into the cadmium sulfide deposition tank 301.

The chemical bath deposition device preferably further comprises a cooling device (not shown), and the coolant in the cooling device is preferably water. The cooling device is covered on the outer wall of the waste liquid storage tank 202, and used for cooling the waste liquid in the waste liquid storage tank, initially reducing the generation rate of CdS. After the cooling of the cooling device in the waste liquid storage tank, the solution in the waste liquid storage tank is cooled from a temperature range from 50 °C to 70 °C at the time of inlet to a temperature range from 20°C to 30 °C, preferably 22 °C.

The waste liquid from the waste liquid storage tank 202 will be pumped into the refrigeration device 203 for further cooling. The temperature of the waste liquid in the refrigeration device 203 is reduced to 15 °C or less, such as 5 °C, 8 °C, so that the formation of CdS enters a stagnant state. As the temperature decreases, the solubility of cadmium sulfide in the waste liquid gradually decreases, and the cadmium sulfide in the waste liquid gradually precipitates in the form of cadmium sulfide particles (particles).

The specific structure of the above refrigeration device 203 may be various, and may be a physical refrigeration device 203 or a chemical refrigeration device 203, which will not be repeated here.

The waste liquid refrigerated by the refrigeration device 203 will enter the filtering device equipped with a filter element (about 0.02 µm), which filters the CdS particles in the waste liquid, and also filters out the separated chemical raw materials: cadmium sulfate and thiourea.

After passing through the filtering device, the solid particles such as CdS are filtered out. This purified chemical liquid will be pumped into the chemical liquid storage tank. The outer wall of the chemical liquid storage tank is preferably provided with a cryogenic maintenance device for maintaining the temperature in the chemical liquid storage tank at a set temperature range to ensure that the solution is kept at a low temperature.

Depending on a situation, the replenishing feeding device may be used to replenish chemicals in the chemical liquid storage tank. The chemical to be added may be a cadmium compound, a NH₄⁺ source, or a sulfur compound.

Preferably, a first regulating valve 209 is provided between the outlet of the chemical liquid storage tank and the inlet of the cadmium sulfide deposition tank 301; a second regulating valve 210 is provided between the inlet of the chemical liquid storage tank and the outlet of the replenishing feeding device. Through the opening and closing of the valve, the liquid circulation between the tanks may be controlled. A person skilled in the art can also understand that a third regulating valve can also be provided between the inlet of the inlet waste liquid storage tank 202 and the outlet of the cadmium sulfide deposition tank 301; a fourth regulating valve can be provided between the outlet of the waste liquid storage tank 202 and the inlet of the refrigeration device 203; a fifth regulating valve can be further provided between the outlet of the refrigeration device 203 and the inlet of the filtering device; and a sixth regulating valve can be provided between the outlet of the filtering device and the inlet of the chemical liquid storage tank, which are not limited herein.

Further, the chemical bath deposition device further comprises an electrical conductivity detector 206 provided in the chemical liquid storage tank and used for measuring an electrical conductivity of the chemical liquid in the chemical liquid storage tank. Based on the above embodiments, the chemical bath deposition device provided by the embodiment of the present disclosure further comprises a control apparatus 212 for controlling opening and closing of the second regulating valve according to the electrical conductivity measured by the electrical conductivity detector.

Further, the chemical bath deposition device further comprises a Cd²⁺ ion detector 207 provided in the chemical liquid storage tank and used for measuring the Cd²⁺ concentration of the chemical liquid in the chemical liquid storage tank.

The overall concentration of ions (eg, cadmium ions, SO₄²⁻, OH⁻, or NH₄⁺) in the chemical solution is calculated based on the measured conductivity data or the concentration of each chemical raw material in the chemical liquid is obtained according to the Cd²⁺ concentration obtained by the Cd²⁺ ion detector. When the concentration of the chemical raw material reaches a set value, the above control apparatus controls the second regulating valve to be closed, thereby stopping addition of the chemical to the chemical liquid in the chemical liquid storage tank.

For example, the electrical conductivity detector is used to measure an overall concentration of cadmium sulfate, ammonia, and thiourea in the chemical solution of the chemical liquid storage tank. The electrical conductivity is positively correlated with the ion concentration in the liquid, and a relationship between electrical conductivity and concentration needs to be characterized during initial adjusting. The relationship curves were obtained by externally detecting the concentrations of Cd²⁺, SO₄²⁻, ammonia, thiourea and the conductivity data in cadmium sulfide waste liquid. Therefore, the Cd²⁺ concentration in the deposition tank is calculated based on the conductivity meter data, and the amount of chemicals to be added is further obtained.

In some embodiments, wherein, preferably the chemical bath deposition device described above further comprises a control apparatus 212 for controlling the opening and closing of the second regulating valve according to the electrical conductivity measured by the conductivity detector or the Cd²⁺ ion concentration detector.

In some embodiments, wherein, preferably the chemical bath deposition device further comprises a pH detecting device for in-line monitoring and adjusting the pH of the chemical liquid in the chemical liquid storage tank.

The chemical bath deposition device as described above, preferably further comprises a heat preservation device 208 provided on an outer wall of the chemical liquid storage tank, and used for maintaining the temperature in the chemical liquid storage tank at a set temperature range.

The chemical bath deposition device as described above, preferably further comprises a first power pump for pumping the waste liquid in the cadmium sulfide deposition tank 301 into the waste liquid storage tank 202.

The chemical bath deposition device as described above, preferably further comprises a second power pump, a third power pump, a fourth power pump, and a fifth power pump, wherein the second power pump is used to pump the waste liquid in the waste liquid storage tank 202 into the refrigeration device 203; the third power pump is used to pump the waste liquid in the refrigeration device 203 into the filtering device 204; the fourth power pump is used to pump the chemical liquid in the filtering device 204 into the chemical liquid storage tank; and the fifth power pump is used to pump the liquid in the chemical liquid storage tank into the cadmium sulfide deposition tank 301.

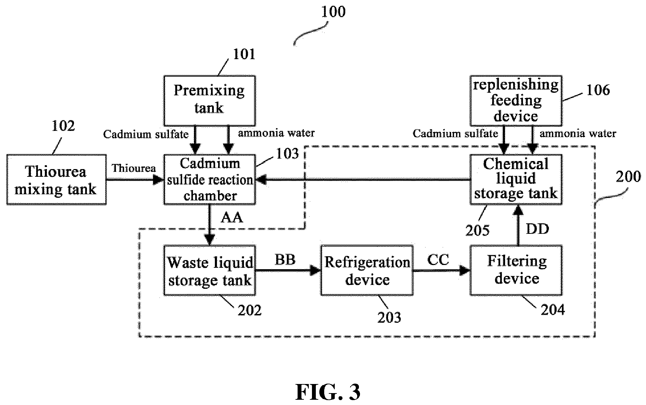

Fig.3 is a schematic structural diagram of a chemical bath deposition device according to other embodiments of the present disclosure. As shown in Fig. 3, these embodiments provide a cadmium sulfide deposition device 100 including a cadmium sulfide deposition tank 301, as well as a premixing tank 101, a sulfide mixing tank 102, a waste liquid storage tank 202, a refrigeration device 203, a filtering device 204, a chemical liquid storage tank 205, and a replenishing feeding device 106. As described above, the waste liquid storage tank 202, the refrigeration device 203, the filtering device 204, and the chemical liquid storage tank 205 constitute the waste liquid recovery system 200 provided by the embodiment of the present disclosure.

Referring to Fig. 3, a chemical deposition solution may be added to the cadmium sulfide deposition tank 301 through the premixing tank 101 and the thiourea mixing tank 102.

In some embodiments, the chemical deposition solution is a cadmium sulfate solution system, including a solution prepared by cadmium sulfate, ammonia water and thiourea, wherein the above premixing tank contains cadmium sulfate and ammonia water, and the above-mentioned sulfide mixing tank is specifically a thiourea mixing tank. The chemical bath deposition system composed of cadmium sulfate, ammonia water and thiourea is added through a premixing tank and a thiourea mixing tank, respectively. The chemical deposition solution after depositing cadmium sulfide enters the waste liquid storage tank 202 as a waste liquid A. And the waste liquid A contains cadmium sulfate, cadmium sulfide particles, ammonia water, and thiourea.

After the chemical reaction is completed and the substrate is taken out, the chemical liquid in the chemical bath deposition tank is introduced into the waste liquid storage tank 202 as waste liquid AA, preferably, the waste liquid AA in the cadmium sulfide deposition tank 301 is pumped into the waste liquid storage tank 202 by the first power pump.

The recovery system preferably further comprises a cooling device, wherein the coolant in the cooling device is preferably water. The cooling device is covered on the outer wall of the waste liquid storage tank 202 and is used for cooling the waste liquid collection process, and initially reducing the generation rate of the CdS.

After the waste liquid A enters the waste liquid storage tank 202, the temperature is lowered, thereby forming a cooled waste liquid BB. The composition of the waste liquid BB is substantially the same as that of the waste liquid AA, but as the temperature is lowered, the cadmium sulfide ions in the solution are lowered, and the cadmium sulfide particles are slightly increased.

The cooled waste liquid BB enters the refrigeration device 203 from the waste liquid storage tank 202, and is further refrigerated. The waste liquid is refrigerated to form a waste liquid CC. The composition of the waste liquid CC is substantially the same as that of the waste liquid BB, but more precipitates such as cadmium sulfide particles and cadmium sulfate are generated due to the refrigerating.

After exiting from the waste liquid storage tank 202, the waste liquid will be pumped into the refrigeration device 203 for further cooling, and the temperature is lowered to below room temperature (5 degrees Celsius), so that the formation of CdS enters a stagnant state.

The refrigeration device 203 may have a various structure, and may be a physical refrigeration device 203 or a chemical refrigeration device 203, which will not be further described herein.

The cooled waste liquid will enter the filtering device 204 equipped with a filter element (about 0.02 µm), which filters the CdS particles in the waste liquid, and also filters out the separated chemical raw materials: cadmium sulfate and thiourea.

After passing through the filtering device 204, the solid particles such as CdS are filtered out. This purified chemical fluid CC will be pumped into the chemical liquid storage tank. The outer wall of the chemical liquid storage tank is preferably provided with a cryogenic maintenance device for maintaining the temperature in the chemical liquid storage tank at a set temperature range to ensure that the solution is kept at a low temperature.

According to a situation, the replenishing feeding device 106 may be used to replenish chemicals in the chemical liquid storage tank 205. The chemicals to be replenished are cadmium sulfate, ammonia, and the like. Preferably, the ratio of the cadmium sulfate and ammonia aqueous solution replenished to the chemical liquid storage tank 205 by the replenishing feeding device 106 and the chemical liquid returned back to the cadmium sulfide reaction tank is 15% to 25%, preferably 20%.

It can be understood by those skilled in the art that the chemical bath deposition device provided by this embodiment may further include a second power pump, a third power pump, a fourth power pump, and a fifth power pump, wherein the second power pump is used to pump the waste liquid in the waste liquid storage tank 202 into the refrigeration device 203; the third power pump is used to pump the waste liquid in the refrigeration device 203 into the filtering device 204; the fourth power pump is used to pump the chemical liquid in the filtering device 204 into the chemical liquid storage tank 205; the fifth power pump is used to pump the liquid in the chemical liquid storage tank 205 into the cadmium sulfide reaction tank 103.

Preferably, a first regulating valve is provided between the outlet of the chemical liquid storage tank 205 and the inlet of the cadmium sulfide reaction tank 103; a second regulating valve is provided between the inlet of the chemical liquid storage tank 205 and the outlet of the replenishing feeding device 106. Through the opening and closing of the valve, the liquid circulation between the tanks is controlled. A person skilled in the art can also understand that a third regulating valve can also be provided between an inlet of the waste liquid storage tank 202 and the outlet of the cadmium sulfide reaction tank 103; a fourth regulating valve can also be provided between the outlet of the waste liquid storage tank 202 and the inlet of the refrigeration device 203; a fifth regulating valve can be further provided between the outlet of the refrigeration device 203 and the inlet of the filtering device 204; and a sixth regulating valve can be provided between the outlet of the filtering device 204 and the inlet of the chemical liquid storage tank 205, which are not limited herein.

Further, the recovery system further comprises an electrical conductivity detector, the electrical conductivity detector is provided in the chemical liquid storage tank and used for measuring the electrical conductivity of the chemical liquid in the chemical liquid storage tank. Based on the above embodiments, the chemical bath deposition device provided by the embodiment of the present disclosure further comprises a control apparatus for controlling opening and closing of the second regulating valve according to an electrical conductivity measured by the electrical conductivity detector.

Further, the recovery system further comprises a Cd²⁺ ion detector, the ion detector is provided in the chemical liquid storage tank and used for measuring the Cd²⁺ concentration of the chemical liquid in the chemical liquid storage tank.

The overall concentration of ions (eg, cadmium ions, SO₄²⁻, OH⁻, or NH₄⁺) in the chemical solution is calculated based on the measured conductivity data or the concentration of each chemical raw material in the chemical liquid is obtained according to the Cd²⁺ concentration obtained by the Cd²⁺ ion detector. When the concentration of the chemical raw material reaches a set value, the above control apparatus controls the second regulating valve to be closed, thereby stopping addition of the chemical to the chemical liquid of the chemical liquid storage tank.

For example, an electrical conductivity detector is used to measure the overall concentration of cadmium sulfate, ammonia, and thiourea in the chemical solution of the chemical liquid storage tank. The electrical conductivity is positively correlated with the ion concentration in the liquid, and the relationship between electrical conductivity and concentration needs to be characterized during initial adjusting. The relationship curves were obtained by externally detecting the concentrations of Cd²⁺, SO₄²⁻, ammonia, thiourea and conductivity data in cadmium sulfide waste liquid. Therefore, the Cd²⁺ concentration in the deposition tank is calculated based on the electrical conductivity data and the amount of chemicals to be added is further obtained.

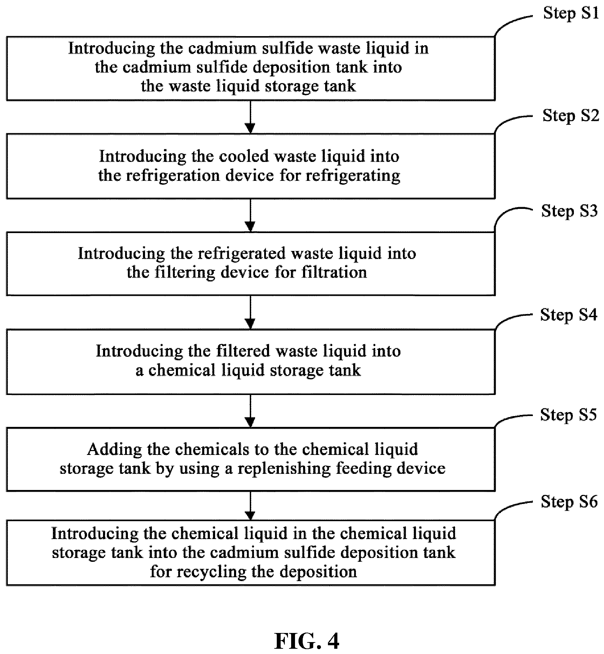

As shown in Fig. 4, an embodiment of the present disclosure further provides a deposition method of a chemical bath deposition device, wherein the deposition method comprises the following steps:
Step S1: introducing the waste liquid in the cadmium sulfide deposition tank 301 into the waste liquid storage tank 202, preferably, performing the first cooling in the waste liquid storage tank 202. The waste liquid may contain a cadmium compound, a cadmium sulfide, a NH₄⁺ source, and a sulfur compound. Preferably, the waste liquid comprises cadmium sulfate, cadmium sulfide, urea, ammonia water, and thiourea.

Specifically, the cadmium sulfide waste liquid in the cadmium sulfide deposition tank 301 may be introduced into the waste liquid storage tank 202 by the first power pump.

Step S2: introducing the cooled waste liquid into the refrigeration device 203 for refrigerating.

Preferably, the cooled waste liquid is introduced into the refrigeration device 203 to lower a temperature of the liquid in the refrigeration device 203 to 5 degrees Celsius or less.

Step S3: introducing the refrigerated waste liquid into the filtering device 204 for filtration.

Specifically, the refrigerated waste liquid is introduced to the filtering device 204, and all cadmium sulfide in the refrigerated waste liquid is filtered out. The filtered waste liquid may contain cadmium sulfate, thiourea, cadmium sulfide, ammonia water, and thiourea.

Step S4: introducing the filtered waste liquid into the chemical liquid storage tank.

This tank has a cryogenic maintenance device to ensure that the solution remains at a low temperature.

Step S5: adding the chemicals to the chemical liquid of the chemical liquid storage tank by using the replenishing feeding device;

Step S6: introducing the chemical liquid in the chemical liquid storage tank into the cadmium sulfide deposition tank 301, and the deposition is performed by repeating the above steps S1 to S6.

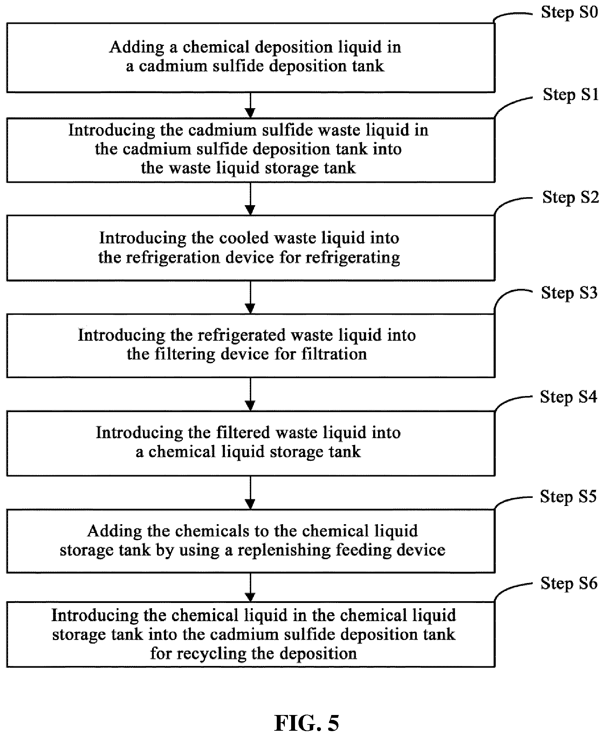

Preferably, as shown in Fig. 5, before step S1, step S0 may also be included, and the step S0 is specifically as follows:
adding a chemical deposition solution into the cadmium sulfide deposition tank 301, wherein the chemical deposition solution may contain a cadmium compound, an OH⁻ compound, an NH₄⁺ source, or a sulfur compound,

Preferably, the cadmium compound may be any one of cadmium sulfate, cadmium chloride, cadmium acetate, cadmium nitrate or any mixture ;

Preferably, the OH⁻ compound may be any one of KOH, NaOH, ammonia water or any mixture .

Preferably, the NH₄⁺ source may be any one of ammonia water, ammonium acetate, urea, or a mixture .

Preferably, the sulfur compound may be any one of thiourea, sodium sulfite or any mixture .

Preferably, the chemical deposition solution may further include an auxiliary agent such as urea, ammonia acetate or the like for improving a crystal form of the cadmium sulfide film deposited on the used substrate.

Preferably, when a chemical deposition solution is added to the cadmium sulfide deposition tank 301, the specific order of adding the materials is cadmium, ammonium source, the substrate to be deposited on the surface, and sulfide.

After adding the mixture solution of sulfides (such as thiourea), cadmium compounds (such as cadmium sulfate) and NH₄⁺ sources (such as ammonia), the chemical reaction starts, i.e., cadmium sulfide particles are formed. The process of CdS chemical bath deposition reaction is as follows:

First step: Cd²⁺ +4NH₃→Cd(NH₃)₄²⁺+2CH₃COO⁻

Second step: Cd(NH₃)₄²⁺, OH⁻ and sulfides such as thiourea, sodium sulfite, etc. diffuse to the surface active sites of the substrate, and the sulfides decompose at the active sites on the surface of the substrate:

NH₂CSNH₂+OH⁻→CH₂N₂+H₂0+HS⁻

Third step: HS⁻ further dissociates to form a divalent sulfur ion:

HS⁻+OH⁻→S²⁻+H₂O

Fourth step: Cd(NH₃)₄²⁺+S²⁻→CdS+4NH₃

In general, the substrate must be added to the chemicals solution prior to addition of the sulfide, and a flow field and a temperature of the chemical solution are uniform and stable at all corners of the substrate. At the end of the reaction, the chemicals are discharged to the waste tank, then into the waste recovery system, and are finally discharged.

Since the thickness of the CdS layer deposited on the substrate is only about 50 nm, there are also a large number of unreacted chemicals, including sulfides (such as thiourea), cadmium compounds (such as cadmium sulfate), and NH4+ sources (such as ammonia) in the chemical solution, in addition to the CdS particles that have been formed in the liquid after the reaction is completed. The chemical deposition solution obtained after deposition of cadmium sulfide is also the waste liquid. Since the above waste liquid is still at the reaction temperature (about 60 degrees Celsius) at the time of discharge, the chemical reaction is continued and is relatively fast, so the concentration of the unreacted chemical is also rapidly lowered and is not easily detected. Since there is no way to quickly control the chemical reaction in the waste liquid, and there is no way to purify and recycle the unreacted chemicals, and thus all the waste liquid is usually discharged after the CdS deposition.

After the chemical deposition solution is added to the cadmium sulfide deposition tank 301, a chemical reaction starts, i.e., cadmium sulfide particles are formed. Thereby, a cadmium sulfide layer can be deposited on the substrate.

Preferably, the chemical deposition solution comprises cadmium sulfate, ammonia water, and thiourea.

The waste liquid A generated after deposition of cadmium sulfide flows from the cadmium sulfide deposition tank 301 into the waste liquid storage tank 202, and the waste liquid A contains cadmium sulfide particles which are not deposited on the substrate, excess cadmium compounds (such as cadmium sulfate), excess NH₄⁺ source, excess sulfur compounds, etc.

In some embodiments, the chemical deposition solution may be a cadmium sulfate solution system comprising a solution prepared from cadmium sulfate, ammonia water, and thiourea, the waste liquid A contains cadmium sulfate, cadmium sulfide particles, aqueous ammonia, and thiourea.

In some embodiments, the chemical deposition solution may be a cadmium chloride solution system comprising a solution prepared from cadmium chloride, ammonia, and thiourea. The waste liquid A contains cadmium chloride, cadmium sulfide particles, ammonia water, and thiourea.

In some embodiments, preferably, the chemical deposition solution may be a cadmium acetate solution system comprising a solution prepared from cadmium acetate, ammonia water, and thiourea, whereby the waste liquid A contains cadmium acetate, cadmium sulfide particles, ammonia water, and thiourea.

After the waste liquid A enters the waste liquid storage tank 202, the temperature is lowered, thereby forming the cooled waste liquid B. The composition of the waste liquid B is substantially the same as that of the waste liquid A, but the cadmium sulfide particles are slightly increased due to the decrease of temperature.

The cooled waste liquid B enters the refrigeration unit 203 from the inlet of the refrigeration device 203, and is further refrigerated. The waste liquid is refrigerated to form waste liquid C. The composition of the waste liquid C is substantially the same as that of the waste liquid B, but more precipitates such as cadmium sulfide particles and cadmium compounds are generated due to the refrigerating.

The chemicals to be added may be a cadmium compound, a NH₄⁺ source or a sulfur compound, in particular a cadmium sulfate, an ammonia water or a thiourea.

After the chemical reaction is completed and the substrate is taken out, the chemical liquid in the chemical bath deposition tank is introduced into the waste liquid storage tank 202 as a waste liquid, preferably, the waste liquid in the cadmium sulfide deposition tank 301 is pumped into the waste liquid storage tank 202 through the first power pump.

Preferably, the chemical liquid storage tank is equipped with a precise electrical conductivity monitor for rapid on-line measurement of the electrical conductivity of the solution.

Preferably, before introducing the chemical liquid in the chemical liquid storage tank into the cadmium sulfide deposition tank 301, the method further comprises:
monitoring the electrical conductivity, Cd²⁺ concentration, and pH value of the chemical solution in the chemical liquid storage tank, calculating the overall concentration of various ions (for example, cadmium ions, SO₄²⁻, OH⁻, or NH₄⁺) in the chemical liquid based on the measured electrical conductivity data, thereby obtaining a concentration of the chemical raw material.

When the concentration of the chemical raw material reaches a set value, the second regulating valve is controlled to be closed, thereby stopping addition of the chemicals to the chemical liquid in the chemical liquid storage tank.

Specifically, the electrical conductivity measures the overall concentration of ions of cadmium compounds, NH₄⁺ sources, and sulfur compounds and so on in the chemical liquid of the chemical liquid storage tank. The electrical conductivity is directly related to the concentration of ions in the liquid, such as the concentration of Cd and SO₄ ions. At the initial adjusting, the relationship between the electrical conductivity and the concentration needs to be characterized. The relationship curve is obtained by externally detecting the impurity concentration and the electrical conductivity data in the waste liquid. Those skilled in the art will understand that the relationship curve is a plot of the overall concentration of ions of the cadmium compound, NH₄⁺ source, and sulfur compound in the waste liquid as a function of the measured electrical conductivity. Further, the amount of chemicals that need to be added is obtained.

Specifically, the electrical conductivity is directly related to the ion concentration in the liquid, and the overall concentration (for example, the concentration of Cd²⁺ and SO₄²⁻) of the cadmium sulfate, ammonia water, and thiourea in the chemical liquid of the chemical liquid storage tank is measured by an electrical conductivity detector. At the initial adjusting, the relationship between electrical conductivity and the concentration needs to be characterized. The relationship curve is obtained by externally detecting the impurity concentration and electrical conductivity data in the waste liquid. Further, the amount of chemicals that need to be added is known.

Further, by monitoring the concentration of Cd²⁺ in the chemical liquid storage tank, and then comparing the concentration of Cd²⁺ in the monitored chemical storage tank and the concentration of Cd²⁺ ions in the initial reaction, a progress of the chemical bath deposition is judged, and thus a concentration of the chemical raw material in the chemical liquid is obtained by calculation.

Further, by monitoring the pH value of the solution in the chemical liquid storage tank, and then comparing the measured pH value with the pH value when cadmium sulfide is deposited in the cadmium sulfide deposition tank 301, the content of ammonia water or alkali solution such as NaOH or KOH to be replenished is further calculated.

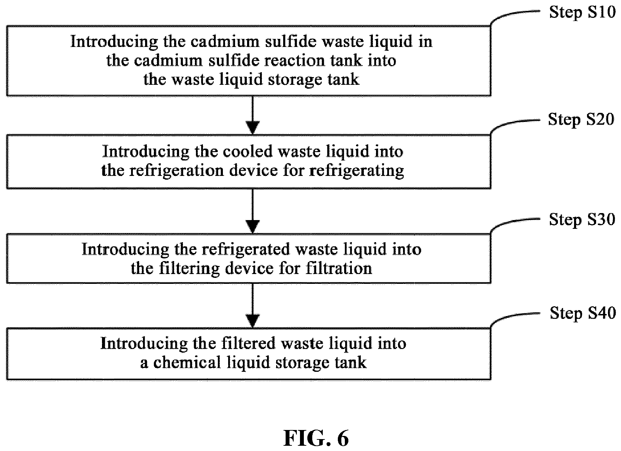

As shown in Fig. 6, the embodiment of the present disclosure further provides a waste liquid recovery method, including:
Step S10: introducing the waste liquid in the cadmium sulfide deposition tank 301 into the waste liquid storage tank 202, preferably, the waste liquid can be cooled in the waste liquid storage tank 202.
Step S20: introducing the cooled waste liquid into the refrigeration device 203 for refrigerating.

The refrigerated waste liquid is introduced into the refrigeration device 203 to lower the temperature of the liquid in the refrigeration device 203 to 5 degrees Celsius or less.

Step S30: introducing the refrigerated waste liquid into the filtering device 204 for filtration.

The refrigerated waste liquid is introduced into the filtering device 204, and all cadmium sulfide in the refrigerated waste liquid is filtered out, and cadmium sulfate and thiourea are filtered out.

Step S40: introducing the filtered waste liquid into the chemical liquid storage tank.

The cadmium sulfide deposition device, the cadmium sulfide layer deposition method, the waste liquid recovery system and the method provided by the embodiments of the present disclosure have the following significant advantages compared with the existing CBD technology, :by recycling and recovery of the waste liquid obtained by depositing cadmium sulfide in the cadmium sulfide deposition tank 301, the utilization rate of cadmium compounds, ammonium sources and the like in the chemical deposition solution is greatly increased, i.e.,from the original 15% to 65%. This solution is especially beneficial for CBD equipment device in the dipping mode, because the dipping mode method requires a large amount of chemicals solution, and the OPEX in the continuous mass production process is high. In general, the wobbling CBD equipment is expensive, but uses less chemicals. This technical solution will make the dipping-type CBD equipment with lower cost have an advantage, which will greatly reduce the overall production and operation cost of the CIGS production line.

By optimizing the process, such as a cooling and refrigerating two-stage cooling process, the chemical deposition solution obtained from the cadmium sulfide deposition tank 301 enters the waste liquid storage tank 202 during the cooling process, the temperature is lowered to room temperature, and the formation of CdS particles (particles) is gradually stagnated under the water cooling effect of the waste liquid storage tank 202, the refrigerating of refrigeration process and cooling process can continuously improve the efficiency of purifying chemical liquid, so that the recycling number of the chemical liquid is increased, further increasing the chemical utilization rate from 65% to 90%.

The construction, features and effects of the present disclosure have been described in detail above with reference to the embodiments shown in the drawings, the above description is only the preferred embodiment of the present disclosure, but the disclosure does not limit the implementation scope as shown in the drawings, all changes which come within the spirit and scope of the invention are intended to be included within the scope of the present disclosure.

## Claims

1. A waste liquid recovery system (200), **characterized in that** the waste liquid recovery system (200) comprises:
a waste liquid storage tank (202) configured to store waste liquid generated in a cadmium sulfide deposition tank (301);
a refrigeration device (203) configured to refrigerate the stored waste liquid;
a filtering device (204) configured to filter the refrigerated waste liquid; and
a chemical liquid storage tank (205) configured to store the filtered waste liquid;
an inlet of the waste liquid storage tank (202) is configured to be connected to an outlet of the cadmium sulfide deposition tank (301);
an outlet of the waste liquid storage tank (202) is configured to be connected to an inlet of the refrigeration device(203);
an outlet of the refrigeration device (203) is configured to be connected to an inlet of the filtering device (204);
an outlet of the filtering device (204) is configured to be connected to an inlet of the chemical liquid storage tank(205).

2. The waste liquid recovery system (200) according to claim 1, **characterized in that** the waste liquid recovery system (200) further comprises a cooling device (211), the cooling device (211) is covered on an outer wall of the waste liquid storage tank (202), substantially, a coolant in the cooling device (211) is water.

3. The waste liquid recovery system (200) according to claim 2, **characterized in that** the outlet of the chemical liquid storage tank (205) is connected to the inlet of the cadmium sulfide deposition tank (301), and a first regulating valve (209) is provided between the outlet of the chemical liquid storage tank (205) and the inlet of the cadmium sulfide deposition tank (301).

4. The waste liquid recovery system (200) according to claim 2, **characterized in that** the waste liquid recovery system (200) further comprises a heat preservation device (208), the heat preservation device (208) is provided on an outer wall of the chemical liquid storage tank (205), and used for maintaining a temperature in the chemical liquid storage tank (205) at a set temperature range.

5. A chemical bath deposition device (300), **characterized in that** the chemical bath deposition device (300) comprises:
a cadmium sulfide deposition tank (301) configured to deposit cadmium sulfide;
a waste liquid storage tank (202) configured to store the waste liquid generated by a deposition of the cadmium sulfide;
a refrigeration device (203) configured to refrigerate the stored waste liquid;
a filtering device (204) configured to filter the refrigerated waste liquid;
a chemical liquid storage tank (205) configured to store the filtered waste liquid; and
a replenishing feeding device (306) configured to replenish a chemical raw material into the chemical liquid storage tank (205);
an inlet of the waste liquid storage tank (202) is connected to an outlet of the cadmium sulfide deposition tank (301);
an outlet of the waste liquid storage tank (202) is connected to an inlet of the refrigeration device (203);
an outlet of the refrigeration device (203) is connected to an inlet of the filtering device (204);
an outlet of the filtering device (204) is connected to an inlet of the chemical liquid storage tank (205);
an outlet of the replenishing feeding device (306) is connected to an inlet of the chemical liquid storage tank (205); and
an outlet of the chemical liquid storage tank (205) is connected to the inlet of the cadmium sulfide deposition tank (301).

6. The chemical bath deposition device (300) according to claim 5, **characterized in that** the chemical bath deposition device (300) further comprises a cooling device (211), the cooling device(211) is covered on an outer wall of the waste liquid storage tank (202), substantially, a coolant in the cooling device (211) is water.

7. The chemical bath deposition device (300) according to claim 5, **characterized in that** a first regulating valve (209) is provided between the outlet of the chemical liquid storage tank (205) and the inlet of the cadmium sulfide deposition tank (301); and
a second regulating valve (210) is provided between the outlet of the replenishing feeding device (306) and the inlet of the chemical liquid storage tank (205).

8. The chemical bath deposition device (300) according to claim 7, **characterized in that** the chemical bath deposition device (300) further comprises an electrical conductivity detector (206), the electrical conductivity detector (206) is provided in the chemical liquid storage tank (205) to measure an electrical conductivity of the waste liquid in the chemical liquid storage tank (205).

9. The chemical bath deposition device (300) according to claim 8, **characterized in that** the chemical bath deposition device further comprises an ion detector (207), and
the ion detector (207) is provided in the chemical liquid storage tank (205) to measure a concentration of Cd²⁺ contained in the waste liquid of the chemical liquid storage tank (205).

10. The chemical bath deposition device (300) according to claim 9, **characterized in that** the chemical bath deposition device further comprises a control apparatus (212), the control apparatus(212) is provided to control opening and closing of the second regulating valve (210) according to the electrical conductivity measured by the electrical conductivity detector (206) or the Cd²⁺ concentration measured by the ion detector (207).

11. The chemical bath deposition device (300) according to claim 5, **characterized in that** the chemical bath deposition device further comprises a heat preservation device (208), the heat preservation device (208) is provided on an outer wall of the chemical liquid storage tank (205) for maintaining a temperature in the chemical liquid storage tank (205) within a set temperature range.

12. A deposition method using the chemical bath deposition device (300) according to claim 5, **characterized in that** the deposition method comprises the following blocks:
introducing the waste liquid in the cadmium sulfide deposition tank (301) into the waste liquid storage tank (202) for storage, and then introducing the waste liquid in the waste liquid storage tank (202) into the refrigeration device (203) for refrigerating;
introducing the refrigerated waste liquid into the filtering device (204) for filtration;
introducing the filtered waste liquid into a chemical liquid storage tank (205) for storage;
adding a chemical raw material to the chemical liquid storage tank (205) by the replenishing feeding device (306); and
introducing a chemical liquid generated by the waste liquid stored in the chemical liquid storage tank (205) and the added chemical raw material, into the cadmium sulfide deposition tank (301) for depositing the cadmium sulfide.

13. The deposition method according to claim 12, **characterized in that** when the waste liquid in the cadmium sulfide deposition tank (301) is introduced into the waste liquid storage tank (202) for storage, the waste liquid stored in the waste liquid storage tank (202) is cooled to a temperature ranging from 20 °C to 30 °C.

14. The deposition method according to claim 12, **characterized in that** when the waste liquid in the waste liquid storage tank (202) is introduced into the refrigeration device (203) for refrigerating, a temperature of the refrigerated waste liquid is less than or equal to 15 °C.

15. The deposition method according to claim 12, **characterized in that** before adding a chemical raw material to the chemical liquid storage tank (205) by the replenishing feeding device (306), the deposition method further comprises:
monitoring an electrical conductivity of the waste liquid stored in the chemical liquid storage tank (205) or monitoring the Cd²⁺ concentration of the waste liquid in the chemical liquid storage tank (205), calculating the content of cadmium particles in the waste liquid, according to the measured electrical conductivity or Cd²⁺ concentration, and then obtaining the concentration of the added chemical raw material according to the content of the cadmium particles.
